# EUROPEAN PATENT APPLICATION

(11) **EP 0 646 963 A1**
(43) Date of publication of application: **05.04.1995**
(21) Application number: 94306866.8
(22) Date of filing: 20.09.1994
(51) Int. Cl.: H01L 23/538, H01L 23/057

(54) **Multi-chip module and manufacturing method thereof**

(30) Priority: 30.09.1993 JP 245304/93
(71) Applicant: KABUSHIKI KAISHA TOSHIBA, Kawasaki-shi, Kanagawa-ken 210 (JP)
(72) Inventor: Fukuoka, Yoshitaka, c/o Intellectual Property Div., Minato-ku, Tokyo (JP)
(74) Representative: Freed, Arthur Woolf

(57) **Abstract**

The multi-chip module comprises a ceramic multi-layer substrate, chip-type electronic parts mount-bonded to the surface of predetermined areas of the ceramic multi-layer substrate, a seal-ring pattern positioned on the surface of the ceramic multi-layer substrate having enclosed a packaging area of the electronic parts, a sealing cap for packaging the electronic parts by sealing open edge to the seal-ring pattern, and pads for mounting input/output terminal leads or pins, which are installed with wires elongated from internal layers of the substrate to the ceramic multi-layer substrate through lead-throughs distributed along the sealing cap, wherein the pads are aligned in a row or alternately aligned in two rows along the sealing cap and the leading parts of the via holes and the pads are alternately aligned in two rows. The multi-chip module manufacturing method comprises; manufacturing a ceramic multi-layer substrate, wherein the pads for mounting input/output terminal leads or pins are aligned in a row or alternately aligned in two rows along the sealed part having the internally wired leading part of the via holes alternately aligned in two rows in the peripheral area; mount-bonding the desired chip-type electronic devices onto the manufactured substrate; and soldering the input/output terminal pins to the pads positioned on the peripheral area onto which the chip-type electronic devices are mount-bonded, using a solder, the melting point of which is 400°C or lower.

## Description

The present invention relates to a multi-chip module, wherein a plurality of unpackaged integrated circuit semiconductor chips (IC chips), along with other kinds of chips including resistor chips and capacitor chips, are mounted on a multi-layer substrate consisting of a base substrate of ceramics and all the chip parts of which are sealed with a cap for instance some kind of metal cap, and a manufacturing method thereof.

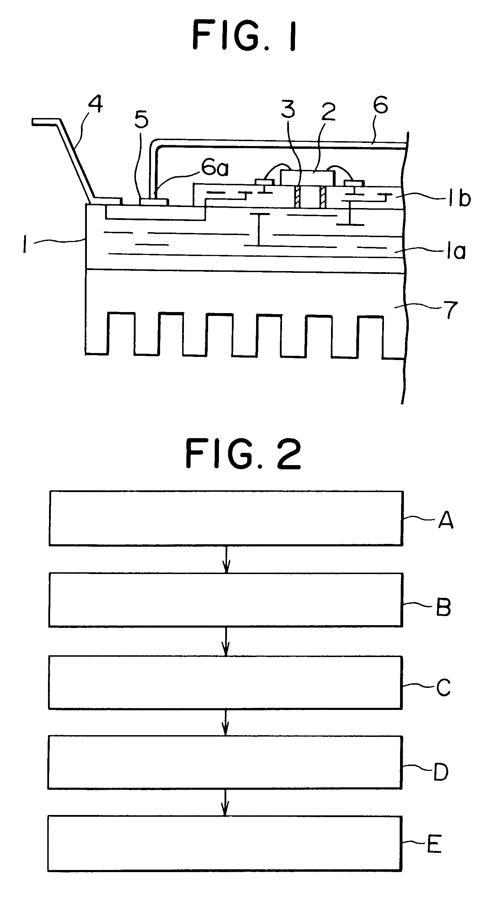

A multi-chip module (abbreviated as MCM herein) has been the subject of much study for its advantages including compactness and multi-function ability of the circuit structure. FIG. 1 is a sectional view showing a structural example of the essential part of a conventional multi-chip module, wherein a ceramic multi-layer substrate 1 comprises a first signal wiring layer 1a using layers of ceramics in the base substrate as dielectric layers and a second signal wiring layer 1b using layers of polyimide resin and the like as dielectric layers. The surface of the second signal wiring layer 1b functions as a mount-bonding area for the chip parts 2 including IC chips, resistor chips and capacitor chips.

The ceramic multi-layer substrate 1 is composed of stepped convex sections wherein the second signal wiring layer 1b is built on and integrated with the first signal wiring layer 1a. In this structure, on the mount-bonding area, thermal via holes 3 are distributed, which penetrates the second signal wiring layer 1b to be thermally connected to the first signal wiring layer 1a by means of mount-bonding chip parts 2. Further, the chip parts 2 mount-bonded to the second signal wiring layer 1b are electrically connected to the input/output terminal pins 4 of MCM. Namely, the chip parts 2 are electrically connected to the leading part of the via hole located on the first signal wiring layer 1a via both the second signal wiring layer 1b and the first signal wiring layer 1a. Further, the chip parts 2 are hermetically sealed, wherein the open edge of the sealing cap 6, a metal cap for example, is sealed to the seal-ring pattern 5 which is placed on the first signal wiring layer 1a surrounding the second signal wiring layer 1b. In this type of MCM, because the chip parts 2 mount-bonded to the second signal wiring layer 1b radiate heat in movement, a heat sink metal fin 7 is commonly installed on the rear side of the ceramic multi-layer substrate 1 (namely, of the first signal wiring layer 1a).

A typical manufacturing process of MCM with the structure is described. FIG. 2 shows a conventional MCM manufacturing flow chart. The desired MCM is manufactured by (a)forming a ceramic multi-layer substrate 1; (b)soldering an input/output terminal pin 4 of MCM to the predetermined area of the ceramic multi-layer substrate 1 using a hard solder (e.g. silver-copper eutectic alloy), the melting point of which is higher than 800°C; (c)mount-bonding so called chip-type electronic parts 2 including the desired integrated circuit semiconductor chips (IC chips) and others; (d)electrically testing the mount-bonded chip parts 2, and when the chip parts 2 pass the test, (e)bonding and hermetically sealing the open edge 6a of the sealing cap 6, with for example a metal cap, on the surface of the seal-ring pattern 5 of the ceramic multi-layer substrate 1 with eutectic solders including Sn/Pb;63/37. Later, a heat sink metal fin can be is installed if needed.

Due to the recent appearance of high speed integrated circuit chips, attempts are being made to improve the electric signal propagation of the ceramic multi-layer substrate 1. One result of these attempts is the ceramic multi-layer substrate 1 with a structure wherein the second signal wiring layer (thin film multi-layer wiring layer) 1b is formed and positioned on a base substrate of ceramics such as alumina (Al₂O₃) or aluminum nitride (AlN), having Cu which has low electric resistivity as a conductor, and polyimide resin which has low relative dielectric constant as an insulator. The method of manufacturing the substrate comprises the following steps; (1)forming of a thin film multi-layer wiring layer of Cu/polyimide resin 1b on a base substrate, (2)fabrication of the desired QFP (quad flat package) or PGA (pin grid array) type input/output leads or pins by soldering and mounting of an input/output terminal leads pins 4 of MCM using a solder, the melting point of which is lower than the temperature which the polyimide resin could be damaged, so as to electrically connect the input/output terminal pin 4, (3)mount-bonding of the chip part such as semiconductor integrated circuit chip (IC chip), (4)electrical testing, and (5)sealing of the non-defectives by means of a seal 6.

These a conventional structure and manufacturing method of MCM, however, has the following defects or problems:
Firstly, during the process of mount-bonding IC chips or at electrical testing, there is a high probability that deformation will occurring in the input/output terminal pins 4 of MCM which have previously been formed and mounted on the ceramic multi-layer substrate 1. The deformation of the input/output terminal pins 4 incurs or causes breakage and/or desorption (mechanical and electrical removal) thereof, which may lead to a decline in the yield of MCM. Higher density packaging (densification or integration) especially incurs an increase in the number of input/output terminal pins 4. In the case of QFP, wherein the pitch of input/output terminal pins 4 has been narrowed corresponding to the increase in the number of pins, thinner input/output terminal pins 4 are utilized, resulting in sharp drops in the yield of MCM.

Secondly, as a countermeasure against the problem of deformation of the input/output terminal pins 4, it is possible to develop new types of carriers which prevent the deformation of input/output terminal pins 4 of MCM at mount-bonding and/or electrical testing. However, the carriers increase the manufacturing cost. Further, in mount-bonding and electrical testing processes, much care is required in desorbing and setting the carriers to the specific fixtures for each step, causing a notable increase in the number of steps.

Thirdly, even for manufacturing a number of MCMs to identical specifications, it is necessary to develop and prepare special fixtures and carriers suitable for each step including mount-bonding, electrical testing or sealing, or that correspond to the specific type of MCM or the structure of the input/output terminals (e.g. QFP or PGA). Thus the number of fixtures and carriers and the development cost thereof increase greatly. Consequently, both the costs involved in developing materials indirectly used in the (MCMs) and the cost of purchasing the materials increase MCM manufacturing costs and induce poorer less competitivity thereof.

One object of this invention is therefore to provide a highly reliable MCM.

Another object of this invention is to provide an MCM with stable function.

A third object of this invention is to provide a method which enables the manufacture of a highly reliable MCM at a low cost.

A fourth object of this invention is to provide a method which enables the manufacture of a highly reliable MCM with a high yield percentage.

The multi-chip module of the present invention comprises a ceramic multi-layer substrate, a chip-type electronic part mount-bonded to the surface of predetermined area of the ceramic multi-layer substrate, a seal-ring pattern positioned on the surface of the ceramic multi-layer substrate enclosing the area which the electronic part is mount-bonded, a sealing cap for packaging the mount-bonded part by sealing open edge thereof to the seal-ring pattern, and a plurality of pads for mounting input/output terminal pins, each of which is installed with a wire elongated from an internal layer of the ceramic multi-layer substrate to the surface of the ceramic multi-layer substrate through the lead-throughs distributed along the sealing cap, wherein the pads are aligned in a row or alternately aligned in two rows along the sealed portion and the leading parts of the internal wiring are alternately aligned in two rows.

The manufacturing method of the multi-chip module of the present invention comprises a first step of manufacturing a ceramic multi-layer substrate for packaging wherein pads for mounting input/output terminal pins are aligned in a row or alternately aligned in two rows along the sealing cap having the internally wired lead part of the via holes alternately aligned in two rows in the peripheral area, a second step of mount-bonding desired chip-type electronic part onto the manufactured ceramic multi-layer substrate for packaging and third step of soldering input/output terminal pins to the pads for mounting input/output terminal pins positioned on the peripheral area onto which the chip-type electronic part are mount-bonded, using a solder the melting point of which is 400°C or lower.

In the third step, it is possible to modify the structure of the input/output terminals of the multi-chip module to take optional forms including QFP, PGA, LGA, and the other I/O type using flexible circuits boards. This matter is one of the most important thing of this invention.

FIG. 1 is a sectional view showing an example of a configuration of the essential part of a usual MCM.

FIG. 2 is a flow chart illustrating a conventional MCM manufacturing process.

FIG. 3 is a top view showing an example of a configuration of the essential part of a MCM in accordance with this invention.

FIG. 4 is a top view showing another example of a configuration of the essential part of a MCM in accordance with this invention.

FIG. 5 is a flow chart illustrating an example of a manufacturing process of a MCM in accordance with this invention.

FIG. 6 is a flow chart illustrating another example of a manufacturing process of a MCM in accordance with this invention.

An embodiment of this invention will be described below with reference to FIG. 1 and FIGS. 3 to 6 thereof.

The MCM structure of the present invention, as described above, has an object to be able to take a desired form including QFP, PGA, LGA, and the other I/O type using flexible circuit boards in the last process of manufacture. Further, by adjusting the input/output terminal pins, the yield of MCM can be increased and the cost of indirect materials can be minimized.

The manufacturing method of MCM of the present invention, as described above, also has an object to be able to form, mount or distribute input/output terminals or input/output terminal pins after mount-bonding chip-type electronic devices to the ceramic multi-layer substrate for packaging chips in the last process of MCM manufacturing. In this manufacturing method, the structure of input/output terminal pins can take various optional forms including QFP, PGA, LGA, and the other I/O type using flexible circuit boards in the last process of MCM manufacture.

Further, with the MCM of the present invention, the pads for mounting input/output terminal pins are aligned in the peripheral area extending along the edge of a seal-ring pattern, wherein the pins and the leading parts of the via holes of internal wires are alternately aligned in two rows along the sealed part. The pads for mounting input/output terminal pins are able to correspond to the specific structure of input/output terminal pins of various kinds of MCM by selecting and setting an appropriate form if needed. Moreover, mounting and connecting input/output terminal pins are done easily and accurately in the last process of MCM manufacturing, which solves all the problems due to the electrical connection of the input/output terminal pins, including the decrease in reliability .

On the other hand, in the MCM manufacturing method of the present invention, soldering and mounting of input/output terminal pins take place in the last process of manufacturing. Therefore, problems due to input/output terminal pins which frequently happen in the conventional method or damages to input/output terminal pins can be totally prevented or solved in the previous processes.

The multi-chip module of the present invention, as shown in FIG. 1, comprises a ceramic multi-layer substrate 1, chip-type electronic parts 2 mount-bonded to predetermined areas of the ceramic multi-layer substrate, a seal-ring pattern 5 on the surface of the ceramic multi-layer substrate 1 for enclosing a packaging area of the electronic parts 2, a sealing cap 6 for packaging the parts to be packaged 2 by sealing open edge 6a to the seal-ring pattern 5, and pads (illustration is omitted) for mounting input/output terminal pins, which are installed with wires internally elongated to the ceramic multi-layer substrate 1 on the sealed part of the sealing cap 6 and are led through and connected to the ceramic multi-layer substrate 1 through via holes distributed in the peripheral area along the edge of the sealed part. Namely, the structure thereof is the same as that of MCM described as a conventional example. In concrete terms, as shown in FIG. 1, a ceramic multi-layer substrate (base substrate) 1 comprises a first signal wiring layer 1a using ceramics as a dielectric layer and a second signal wiring layer 1b using polyimide resin as a dielectric layer. The surface of the second signal wiring layer 1b hereat functions as a mount-bonding area for chip parts 2.

Further, the ceramic multi-layer substrate 1 is composed of stepped convex sections wherein the second signal wiring layer 1b is built on and integrated with the first signal wiring layer 1a. In this configuration, thermal via holes 3 are distributed on the mount-bonding area, penetrating the second signal wiring layer 1b to be thermally connected to the first signal wiring layer 1a. Further, the input/output terminal pins 4 of MCM are electrically connected to the chip parts 2, through the second signal wiring layer 1b and first signal wiring layer 1a, as well as through the pads 4a for mounting input/output terminal pins positioned around leading parts of the via holes 4b located on the first signal wiring layer 1a.

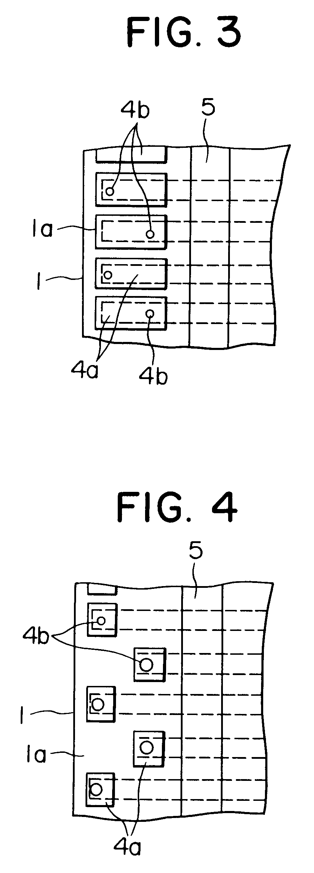

The present invention is featured with the arrangement or distribution of the pads 4a for mounting input/output terminal pins. FIG. 3 and FIG. 4 are top views showing examples of the structure of an important part with different arrangements or distributions of the pads 4a for mounting input/output terminal pins. As can be seen in FIG. 3 and FIG. 4, the pads 4a for mounting input/output terminal pins are aligned in the peripheral area along the outer edge of the sealed part (seal-ring pattern 5). Further, the leading parts of the via holes 4b leading through the first signal wiring layer 1a are electrically connected, arranged or alternately aligned. Further, the pads 4a for mounting input/output terminal pins coat and are electrically connected to the internally wired leads of the alternately aligned via holes 4b. The pads 4a for mounting input/output terminal pins are adjusted corresponding to the structure of the input/output terminal pins of MCM, including QFP and PGA. When the pads 4a for mounting input/output terminal pins are properly adjusted to the structure of the input/output terminal pins, standardization of the first signal wiring layer 1a (usually including signal lines, the main conductor pattern layer of which is the power unit or ground unit), which constitutes the ceramic multi-layer substrate 1, becomes possible.

Moreover, the chip parts 2 are hermetically sealed with the area of chip parts are mount-bonded on the second signal wiring layer 1b. Namely, the chip parts to be packaged 2 mount-bonded on the mount-bonded second signal wiring layer 1b are hermetically sealed by sealing the open edge of the sealing cap 6, to the seal-ring pattern 5 which is placed on the first signal wiring layer 1a having enclosed the second signal wiring layer 1b. Further, on the rear side of the ceramic multi-layer substrate 1 (namely, of the first signal wiring layer 1a), a heat sink metal fin 7 is commonly installed to dissipate heat produced by the movement of the chip parts to be packaged.

Next, the manufacturing method of MCM of the present invention will be described.

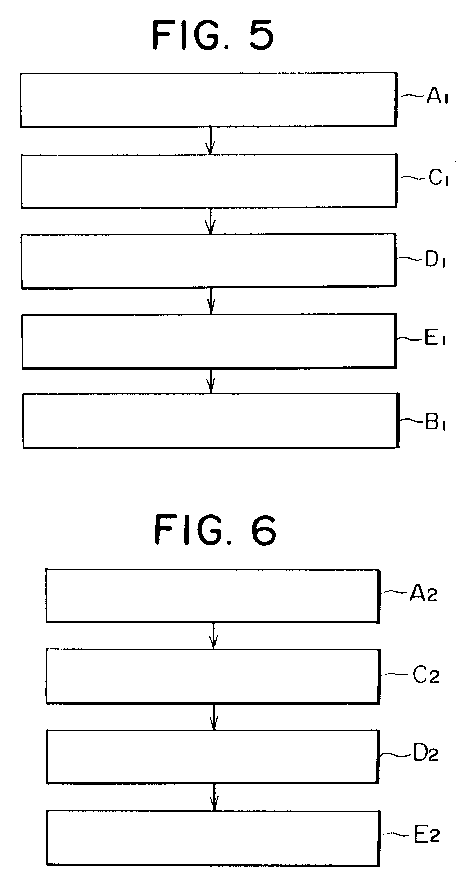

FIG. 5 and FIG. 6 show the flow charts of the MCM manufacturing method of the present invention. Firstly, the ceramic multi-layer substrate 1 is formed (Step A1, A2), which is the usual process of forming a base substrate (first signal wiring layer) 1a using ceramics as a dielectric layer. Needless to say, the base substrate comprises sufficient internal wiring to be electrically connected to the second signal wiring layer 1b which is to be formed and layered thereon in the next step. Further, prior to forming the second signal wiring layer 1b, the pads 4a for mounting input/output terminal pins are aligned in a row or in two rows by being electrically connected to the leading parts of the via holes 4b fetched to the peripheral area. It is also possible to form and align the pads 4a for mounting input/output terminal pins when the conductor layer is formed on the top surface of the signal wiring layer 1b (including mount-bonding area). The leading parts 4b to be electrically connected with the pads 4a for mounting input/output terminal pins are alternately aligned in two rows. The shape of the pads 4a is selected and determined according to the types of MCM thereof, such as QFP type or PGA type. Generally, the optimum shape of the pads for QFP type is a rectangle (see FIG 3), and the optimum shape of the pads for PGA type is a square(see FIG. 4).

Next step is to form a second signal wiring layer 1b, having polyimide resin as dielectric layers and Cu wiring layers layered alternately, by the conventional method of forming a thin film multi-layer wiring layer. Prior to forming the second signal wiring layer 1b, at the time of forming the pads 4a for mounting input/output terminal pins, or when the conductor layer of the top surface of the second signal wiring layer 1b is formed using a conventional method, a seal-ring pattern 5 is to be formed and attached to the base substrate 1a enclosing the second signal wiring layer 1b. Here, the location of the seal-ring pattern 5 is along and inside of the pads 4a for mounting input/output terminal pins and outside of the second signal wiring layer 1b.

Onto the predetermined area of thus formed ceramic multi-layer substrate 1, namely the predetermined area of the second signal wiring layer 1b, integrated circuit semiconductor chips (IC chips) and chip-type electronic devices 2 including other chip parts are mount-bonded (Step C1, C2). Then, electrical function tests of MCM structure, if needed (Step D1, D2), and other manufacturing or processing steps including sealing of the open edge 6a of the sealing cap 6 by soldering with eutectic solders such as Sn/Pb;63/37 (Step E1) are to be carried out.

In the last step of manufacturing, the desired input/output terminal pins are installed by being soldered respectively to the pads 4a, formed and positioned in the peripheral area on the first signal wiring layer 1a, using soft solder, the melting point of which is lower than 400°C. The reason soft solder with a melting point under 400°C is used for soldering the pads 4a is that soft solder with a melting point over 400°C may have a bad effect on the polyimide resin used as a dielectric layer for the electronic devices consisting of MCM and the second signal wiring layer 1b.

In the manufacturing method shown in the flow chart in FIG. 5, the sealing and shielding of the open edge 6a of the sealing cap 6 to the seal-ring pattern 5 (Step E1) and the soldering of the input/output terminal pins to the pads 4a (Step B1) are done separately. By carrying out these soldering processes at the same time (Step E2), however, the soldering time can be shortened.

It is to be understood that the present invention is not limited in its application to the examples illustrated above, since the invention is capable of other embodiments and of being practiced in various ways without departing from the spirit of the invention. For example, a ceramic multi-layer substrate can use a base substrate having other ceramics as dielectric layers instead of the base substrate (first signal wiring layer) having alumina (Al₂O₃) or aluminum nitride (AlN) as dielectric layers. Instead of using the second signal wiring layer having polyimide resin as a dielectric layer, using a wiring layer with other resins or ceramics is also possible.

As described above, the configuration of MCM of the present invention, the structure and the arrangement of the pads for mounting input/output terminal pins, and the shape of the leads of connection parts are to be selected and determined. Such a selection process ensures the connection or the installation of reliable input/output terminal pins and improves functional reliability. Especially, in the structure, adjusting the pads for mounting input/output terminal pins according to the structure of input/output terminal pins of MCM, such as QFP type or PGA type, enables the standardization, at least, of the first signal wiring layer composing the ceramic multi-layer substrate, which is a large practical benefit.

Further, in the manufacturing method of the present invention, input/output terminal pins are installed in the last step of manufacture so that deformation of the input/output terminal pins and the difficulties in conveyance, which often occurs in the conventional method, can totally be avoided. Namely, there is no need for special carriers in MCM manufacture, which is beneficial in terms of mass production and manufacturing cost, including a good yield.

## Claims

1. A multi-chip module, comprising:
a ceramic multi-layer substrate,
a chip-type electronic parts mount-bonded on the surface of the predetermined area of said ceramic multi-layer substrate;
a seal-ring pattern positioned on the surface of the ceramic multi-layer substrate enclosing the mount-bonded area;
a sealing cap for packaging said mount-bonded part by sealing open edge thereof to said seal-ring pattern, and a pad for mounting an input/output terminal pin, which is installed with a wire elongated from an internal layer of said ceramic multi-layer substrate to the surface of the ceramic multi-layer substrate through the lead-throughs distributed along said sealing cap,
wherein said pads are aligned in a row or alternately aligned in two rows along the sealed portion and the leads of the internal wiring are alternately aligned in two rows.

2. The multi-chip module according to Claim 1, wherein the pads, coating the internally wired leading parts of the via holes alternately aligned in two rows, are set in a manner corresponding to the structure of the input/output terminal pins of said multi-chip module of said pads comprised.

3. The multi-chip module according to Claim 1, wherein a ceramic multi-layer substrate comprises a first signal wiring layer using ceramic such as Al₂O₃ as a dielectric layer and a second signal wiring layer using polyimide resin as a dielectric layer, and the chip-type electronic parts are mount-bonded on said second signal wiring layer.

4. The multi-chip module according to Claim 2, wherein a ceramic multi-layer substrate comprises a first signal wiring layer using ceramic such as Al₂O₃ as a dielectric layer and a second signal wiring layer using polyimide resin as a dielectric layer, and the chip-type electronic parts are mount-bonded on said second signal wiring layer.

5. The multi-chip module as claimed in Claim 1, wherein a ceramic multi-layer substrate comprises a first signal wiring layer using ceramic such as AlN as a dielectric layer and a second signal wiring layer using polyimide resin as a dielectric layer, and the chip-type electronic parts are mount-bonded on said second signal wiring layer.

6. The multi-chip module as claimed in Claim 2, wherein a ceramic multi-layer substrate comprises a first signal wiring layer using ceramic such as AlN as a dielectric layer and a second signal wiring layer using polyimide resin as a dielectric layer, and the chip-type electronic parts are mount-bonded on said second signal wiring layer.

7. The multi-chip module as claimed in Claim 1, wherein the second signal wiring layer to mount-bond the chip-type electronic parts comprises a Cu conductor wiring layer and polyimide resin dielectric layer.

8. The multi-chip module as claimed in Claim 2, wherein the second signal wiring layer to mount-bond the chip-type electronic parts comprises a Cu conductor wiring layer and polyimide resin dielectric layer.

9. The multi-chip module as claimed in claim 3, wherein the second signal wiring layer to mount-bond the chip-type electronic parts comprises a Cu conductor wiring layer and polyimide resin dielectric layer.

10. The multi-chip module as claimed in Claim 4, wherein the second signal wiring layer to mount-bond the chip-type electronic parts comprises a Cu conductor wiring layer and polyimide resin dielectric layer.

11. The multi-chip module as claimed in Claim 5, wherein the second signal wiring layer to mount-bond the chip-type electronic parts comprises a Cu conductor wiring layer and polyimide resin dielectric layer.

12. The multi-chip module as claimed in Claim 6, wherein the second signal wiring layer to mount-bond the chip-type electronic parts comprises a Cu conductor wiring layer and polyimide resin dielectric layer.

13. A manufacturing method for a multi-chip module, comprising:
A step of manufacturing a ceramic multi-layer substrate for packaging, wherein pads for mounting input/output terminal pins are aligned in a row or alternately aligned in two rows along with internally wired leading parts of the via holes in the peripheral area along the sealed portion;
A step of mount-bonding chip-type electronic part onto said manufactured ceramic multi-layer substrate for packaging; and
A step of soldering input/output terminal leads or pins to the pads for mounting input/output terminal pins in the peripheral area to which said electronic parts are mount-bonded using a solder, the melting point of which is 400°C or lower.

14. A manufacturing method of a multi-chip module, comprising:
A step of manufacturing a ceramic multi-layer substrate for packaging, wherein pads for mounting input/output terminal pins are aligned in a row or alternately aligned in two rows along with internally wired leading parts of the via holes in the peripheral area along the sealing cap;
A step of mount-bonding chip-type electronic part onto said manufactured ceramic multi-layer substrate for packaging; and
A step of soldering input/output terminal pins to the pads for mounting input/output terminal pins in the peripheral area to which said electronic part are mount-bonded using a solder, the melting point of which is 400°C or lower, and of sealing the open edge of sealing cap to a seal-ring pattern positioned to enclose a mount-bonding area of said electronic parts using a solder, the melting point of which is 400°C or lower.

15. The manufacturing method according to Claim 14, wherein soldering the input/output terminal pins and sealing of the open edge of the sealing cap are carried out at the same time.
